(19) Europäisches Patentamt
European Patent Office
Office européen des brevets

(11) **EP 4 170 733 A1**

(12) **EUROPEAN PATENT APPLICATION**

(43) Date of publication:
**26.04.2023 Bulletin 2023/17**

(21) Application number: **22197722.6**

(22) Date of filing: **26.09.2022**

(51) International Patent Classification (IPC):
**H01L 31/108** (2006.01)   **H01L 31/0224** (2006.01)
**H01L 31/12** (2006.01)   **H01L 27/146** (2006.01)

(52) Cooperative Patent Classification (CPC):
**H01L 31/108; H01L 27/14601; H01L 31/022408;**
**H01L 31/022466; H01L 31/022475;**
**H01L 31/022491; H01L 31/12;** H01L 27/14643

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **22.10.2021 KR 20210141935**

(71) Applicant: **Samsung Electronics Co., Ltd.**
**Gyeonggi-do, 16677 (KR)**

(72) Inventor: **BAIK, Chanwook**
**Suwon-si (KR)**

(74) Representative: **Elkington and Fife LLP**
**Prospect House**
**8 Pembroke Road**
**Sevenoaks, Kent TN13 1XR (GB)**

(54) **PHOTODIODE AND ELECTRONIC DEVICE INCLUDING THE SAME**

(57)   A photodiode includes: a semiconductor layer; a first conductive layer on the semiconductor layer and including a transparent conductive oxide; and a second conductive layer arranged between the semiconductor layer and the first conductive layer, having a work function different from a work function of the first conductive layer, and forming a Schottky junction structure with the semiconductor layer. The work function of the second conductive layer is set to lower the Schottky-barrier height, so that light in a wide wavelength band may be sensed.

FIG. 1

EP 4 170 733 A1

**Description**

FIELD OF THE INVENTION

The disclosure relates to a photodiode and an electronic device including the same.

BACKGROUND OF THE INVENTION

A silicon-based P-N junction that mainly operates in a visible light band is widely used for related art photodiodes or photo sensors. In particular, this structure is used in various kinds of CMOS image sensors because silicon has high light absorption in the visible light band, excellent photocurrent linearity, high quantum efficiency (~80 %) and low noise, and low price.

However, a photodiode utilizing a silicon P-N junction cannot absorb photons with energy less than the bandgap energy (-1.12 eV) of silicon. Accordingly, a silicon photodiode or a silicon CMOS image sensor using the same is widely used in visible light cameras operating in a light wavelength range of 400 nm to 700 nm.

In a near infrared band (700 nm to 1,600 nm), which is a longer wavelength than visible light band, silicon does not absorb light well, and thus, it is necessary to use materials with low bandgap energy such as Ge or InGaAs. However, it is difficult to grow or synthesize these materials, and in particular, it is difficult to form them on a silicon substrate, and thus, they are limitedly used in very expensive or specific products.

SUMMARY OF THE INVENTION

Provided are photodiodes capable of sensing light in a wide wavelength band.

Provided are electronic devices using photodiodes.

Additional aspects will be set forth in part in the description which follows and, in part, will be apparent from the description, or may be learned by practice of the presented embodiments of the disclosure.

According to an aspect of the disclosure, there is provided a photodiode including: a semiconductor layer, a first conductive layer provided on the semiconductor layer and including a transparent conductive oxide and a second conductive layer arranged between the semiconductor layer and the first conductive layer, the second conductive layer configured to have a second work function different from a first work function of the first conductive layer, and configured to form a Schottky junction structure with the semiconductor layer.

The first conductive layer may include a metallic layer having a thickness less than 10nm or may include a transparent conductive oxide.

The second work function of the second conductive layer may be set to have a second Schottky-barrier height of the Schottky junction structure lower than a first Schottky-barrier height of a Schottky junction structure in which a material of the first conductive layer and a material of the semiconductor layer are combined.

The semiconductor layer may be of an n-type, and the second work function of the second conductive layer satisfies the following condition: $\varphi_M > \varphi_{Mi} > \chi_s$, wherein $\varphi_M$ is the work function of the first conductive layer, $\varphi_{Mi}$ is the work function of the second conductive layer, and $\chi_s$ is electron affinity of the semiconductor layer.

The semiconductor layer may be of a p-type, and the second work function of the second conductive layer satisfies the following condition: $\varphi_M < \varphi_{Mi} < \chi_s + E_g$, wherein $\varphi_M$ is the work function of the first conductive layer, $\varphi_{Mi}$ is the work function of the second conductive layer, $\chi_s$ is electron affinity of the semiconductor layer, and $E_g$ is bandgap energy of the semiconductor layer.

The second conductive layer may include a metal, an alloy, a metal oxide, a metal nitride, or a silicide.

A thickness of the second conductive layer may be greater than 0 and less than or equal to 10 nm.

The photodiode may further include: a silicon substrate, wherein the semiconductor layer is a partial area of the silicon substrate.

The photodiode may further include a plurality of electrodes provided on the silicon substrate, the plurality of electrodes configured to apply an electrical signal to the Schottky junction structure or to measure an electrical signal generated in the Schottky junction structure.

The silicon substrate may further include an ohmic contact area spaced apart from the Schottky junction structure, the ohmic contact area having a higher doping concentration than a doping concentration of the semiconductor layer.

The photodiode may further include: a first electrode in electrical contact with the first conductive layer, and a second electrode in electrical contact with the ohmic contact area.

The photodiode may be configured to sense light in visible and infrared bands.

According to another aspect of the disclosure, there is provided an image sensor including: a sensor array including a plurality of light-sensing elements, each of the plurality of light-sensing elements including a photodiode; and a processor configured to read a photoelectric signal generated from each of the plurality of light-sensing elements, wherein the photodiode includes: a semiconductor layer; a first conductive layer provided on the semiconductor layer and including a transparent conductive oxide; and a second conductive layer arranged between the semiconductor layer and the first conductive layer, the second conductive layer configured to have a second work function different from a first work function of the first conductive layer, and configured to form a Schottky junction structure with the semiconductor layer.

The image sensor may further include a filter array provided on the sensor array and including a plurality of filter elements respectively facing the plurality of light-sensing elements.

The plurality of filter elements may include a red filter, a blue filter, and a green filter, and the processor is further configured to process the photoelectric signal to form a visible light image.

The plurality of filter elements may include a band pass filter of a visible light band and a band pass filter of an infrared band.

The plurality of filter elements may include a plurality of filter groups that are repeatedly arranged two-dimensionally, wherein each of the plurality of filter groups includes a red filter, a green filter, a blue filter, and an infrared filter arranged to face the plurality of light sensing elements, respectively.

The processor may be further configured to process the photoelectric signal to form a visible light image and an infrared image.

The processor may be further configured to process the photoelectric signal to form a 3D image.

The filter element may include an infrared band-pass filter, and the processor is further configured to process the photoelectric signal to form an infrared image.

According to another aspect of the disclosure, there is provided an electronic device including: a lens assembly configured to form an optical image by focusing light reflected by an object; and an image sensor configured to convert the optical image formed by the lens assembly into an electrical signal, wherein the image sensor includes a photodiode, which includes: a semiconductor layer; a first conductive layer provided on the semiconductor layer and including a transparent conductive oxide; and a second conductive layer arranged between the semiconductor layer and the first conductive layer, the second conductive layer configured to have a second work function different from a first work function of the first conductive layer, and configured to form a Schottky junction structure with the semiconductor layer.

According to another aspect of the disclosure, there is provided an optical integrated circuit including: a substrate; a light source on the substrate; an optical waveguide configured to transmit light from the light source; and a photodiode configured to convert the light transmitted through the optical waveguide into an electrical signal, wherein the photodiode includes: a semiconductor layer; a first conductive layer provided on the semiconductor layer; and a second conductive layer arranged between the semiconductor layer and the first conductive layer, the second conductive layer configured to have a second work function different from a first work function of the first conductive layer, and configured to form a Schottky junction structure with the semiconductor layer.

The first conductive layer may include a metallic layer having a thickness less than 10nm or include a transparent conductive oxide.

The substrate may include a silicon substrate, and a semiconductor layer of the photodiode includes a silicon-based semiconductor material.

The light source may be configured to output light in a wavelength range of about 800 nm to about 1,700 nm.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view illustrating a schematic structure of a photodiode according to an example embodiment;
FIG. 2A is an energy band diagram of the photodiode of FIG. 1 for a state in which a bias voltage is not applied and FIG. 2B is an energy band diagram of the photodiode of FIG. 1 for a state in which a reverse bias voltage is applied;
FIG. 3 is a cross-sectional view illustrating a schematic structure of a photodiode according to another example embodiment;
FIG. 4A is an energy band diagram of the photodiode of FIG. 3 for a state in which a bias voltage is not applied and FIG. 4B is an energy band diagram of the photodiode of FIG. 3 for a state in which a reverse bias voltage is applied;
FIGS. 5A and 5B are respectively energy band diagrams of a photodiode according to a comparative example for a state in which there is no bias voltage and a state in which a reverse bias voltage is applied;
FIGS. 6 to 9 are cross-sectional views illustrating schematic structures of various examples of photodiodes implemented on a silicon substrate according to an example embodiment;
FIGS. 10A and 10B are graphs illustrating photoelectric signal measurement results for a photodiode according to an example embodiment;

FIG. 11 is a cross-sectional view illustrating a schematic structure of an image sensor according to an example embodiment;

FIG. 12 is a block diagram illustrating a circuit configuration of the image sensor of FIG. 11;

FIGS. 13 to 15 are plan views illustrating examples of filter arrays that may be included in the image sensor of FIG. 11; and

FIG. 16 is a block diagram conceptually illustrating an exemplary configuration of an optical integrated circuit according to an example embodiment.

DETAILED DESCRIPTION

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. The embodiments described below are only examples, and thus, it should be understood that the embodiments may be modified in various forms. Like reference numerals refer to like elements throughout. In the drawings, the sizes of constituent elements may be exaggerated for clarity.

For example, when an element is referred to as being "on" or "above" another element, it may be directly on the other element, or intervening elements may also be present.

It will be understood that, although the terms "first," "second," etc. may be used herein to describe various elements, these elements should not be limited by these terms. These terms are used only to differentiate an element from another element. These terms do not limit the material or structure of the components.

As used herein, the singular forms "a," "an," and "the" are intended to include the plural forms as well, unless the context clearly indicates otherwise. In addition, it will be understood that when a unit is referred to as "comprising" another element, it does not preclude the possibility that one or more other elements may exist or may be added.

In addition, the terms "-er", "-or", and "module" described in the specification mean units for processing at least one function and/or operation and can be implemented by hardware components or software components and combinations thereof.

The use of the terms "a," "an," and "the" and similar referents is to be construed to cover both the singular and the plural.

Operations constituting a method may be performed in any suitable order unless explicitly stated that they should be performed in the order described. Further, the use of any and all examples, or exemplary language (e.g., "such as") provided herein, is intended merely to better illuminate the inventive concept and does not pose a limitation on the scope of the disclosure unless otherwise claimed.

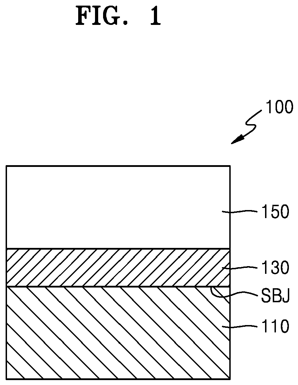

FIG. 1 is a cross-sectional view illustrating a schematic structure of a photodiode according to an example embodiment.

According to an example embodiment, a photodiode 100 includes a semiconductor layer 110, a first conductive layer 150 on the semiconductor layer 110, and a second conductive layer 130 on the first conductive layer 150. According to an example embodiment, the second conductive layer 130 is provided between the first conductive layer 150 and the semiconductor layer 110.

The first conductive layer 150 includes a transparent conductive oxide having a property of being transparent to light in an infrared to visible ray band. The first conductive layer 150 may include, for example, ITO, IWO, IZO, GZO, GIZO, or AZO. The first conductive layer 150 may include a very thin metallic layer less than 10 nm thickness, and the metallic layer may include, for example, Al, AlNd, Ti, TiN, Ni, Pt, W, Cr, Mo, Ru or Cu.

The second conductive layer 130 forms a Schottky junction structure SBJ with the semiconductor layer 110. According to an example embodiment, the second conductive layer 130 may be made of a material having a work function different from a work function of the first conductive layer 150. The work function of the second conductive layer 130 is determined considering materials of the adjacent first conductive layer 150 and the semiconductor layer 110 to lower a Schottky-barrier height. For instance, the work function of the second conductive layer 130 may be determined based on materials of the adjacent first conductive layer 150 and the semiconductor layer 110 to reduce a Schottky-barrier threshold. The work function of the second conductive layer 130 may be set such that, for example, a Schottky-barrier height formed in the Schottky junction structure SBJ is lower than a Schottky-barrier height when a Schottky junction structure is formed with two layers of a material constituting the first conductive layer 150 and a material constituting the semiconductor layer 110. The Schottky-barrier height is energy required for carriers formed in the second conductive layer 130 by incident light to move to the semiconductor layer 110, and may be used interchangeably with the expression of Schottky barrier energy, hereinafter. The second conductive layer 130 may include a metal, an alloy, a metal oxide, a metal nitride, or a silicide. The second conductive layer 130 may include, for example, IZO, GIZO, AZO, TiN, Ti, Al, AlNd, Pt, Ni, silicide, or oxide. Silicide may include, for example, PtSi, NiSi, IrSi, OsSi, WSi or RuSi.

The thickness of the second conductive layer 130 is set to a thickness through which light incident through the first conductive layer 150 may pass. The thickness of the second conductive layer 130 may be greater than 0 and less than or equal to about 10 nm. The thickness of the second conductive layer 130 may be 5 nm or less or 3 nm or less.

The semiconductor layer 110 may include a silicon semiconductor. The semiconductor layer 110 may be n-Si. The work function of the second conductive layer 130 is set differently according to the material of the semiconductor layer 110, the conductivity type (n-type or p-type), and the work function of the first conductive layer 150.

When the semiconductor layer 110 is n-type, the work function of the second conductive layer 130 may satisfy the following requirements.

$$\varphi_M > \varphi_{Mi} > \chi_s \quad (1)$$

Where $\varphi_M$ is the work function of the first conductive layer 150, $\varphi_{Mi}$ is the work function of the second conductive layer 130, and $\chi_s$ is electron affinity of the semiconductor layer 110.

When the first conductive layer 150 is ITO and the semiconductor layer 110 is n-Si, the second conductive layer 130 may be, for example, TiN. However, this is only exemplary and is not limited thereto. As the second conductive layer 130, in addition to TiN, a metal nitride such as AlN, TaN, Ta2N, Ta3N5, W2N, WN, or WN2 may be used, and a material having a relatively small work function, such as Ta, Al, Ti, Mo, V, Mn, Nb or Mo, may be used.

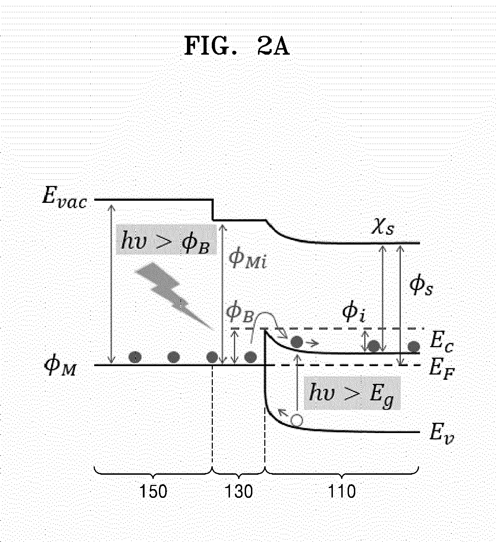

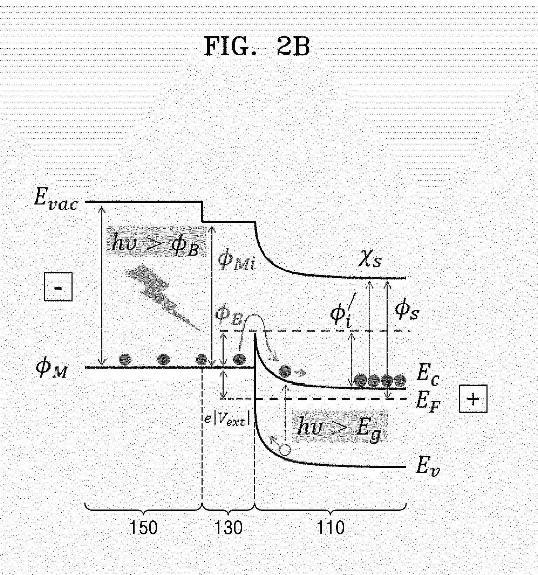

FIG. 2A is an energy band diagram of the photodiode of FIG. 1 for a state in which a bias voltage is not applied and FIG. 2B is an energy band diagram of the photodiode of FIG. 1 for a state in which a reverse bias voltage is applied. In FIGS. 2A and 2B, the work function ($\varphi_{Mi}$) of the second conductive layer 130 is shown according to the requirement of Equation (1). In FIGS. 2A and 2B, Evac is energy at vacuum level, Ec is energy at a bottom of the conduction band, Ev is energy at a top of the valence band, Ef is the Fermi energy at thermal equilibrium, hu is the energy of the incident light, and Eg is the bandgap energy of the semiconductor layer. In particular, hv (or h(nu)) is Planck's equation, where h is Planck's constant and v is frequency.

The Schottky-barrier height (energy) ($\varphi_B$) may be expressed by the following equation.

$$\phi_B = (\phi_{Mi} - \phi_s) + (E_c - E_F)$$
$$= \phi_{Mi} - \chi_s \quad (2)$$

When the first conductive layer 150 is ITO, the second conductive layer 130 is TiN, and the semiconductor layer 110 is n-Si, $\varphi_B$ becomes 4.5-4.05=0.45 eV according to Equation (2).

When a Schottky barrier is formed by the combination of ITO and n-Si, the Schottky-barrier height is calculated by the formula $\varphi_M$-$\chi_s$, and is 4.7-4.05=0.65 (eV).

That is, the Schottky-barrier height (energy) in an embodiment is lower than a Schottky-barrier height when the material of the first conductive layer 150 and the material of the semiconductor layer 110 are combined. When the Schottky-barrier height is reduced, light energy that may be sensed by the photodiode 100 is lowered, so that light having a longer wavelength may be sensed.

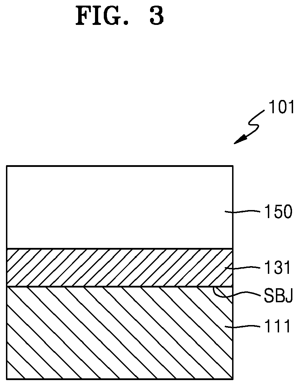

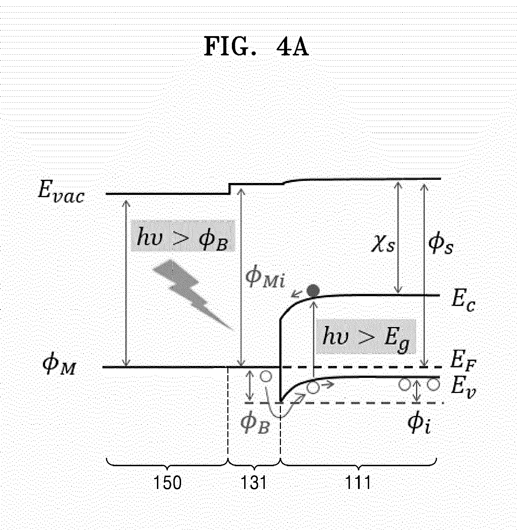

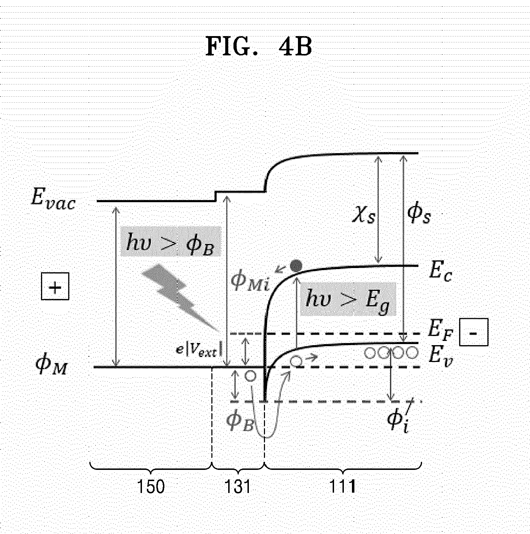

FIG. 3 is a cross-sectional view illustrating a schematic structure of a photodiode according to another example embodiment. FIG. 4A is an energy band diagram of the photodiode of FIG. 3 for a state in which a bias voltage is not applied and FIG. 4B is an energy band diagram of the photodiode of FIG. 3 for a state in which a reverse bias voltage is applied.

According to an example embodiment illustrated in FIG. 3, a photodiode 101 includes a semiconductor layer 111, the first conductive layer 150 on the semiconductor layer 111, and a second conductive layer 131 on the first conductive layer 150. According to an example embodiment, the second conductive layer 131 may be provided between the semiconductor layer 111, the first conductive layer 150.

The photodiode 101 of the example embodiment in FIG. 3 differs from the photodiode 100 of FIG. 1 in that the semiconductor layer 111 includes p-Si, and thus the work function of the second conductive layer 131 is set. The work function of the second conductive layer 131 satisfies the following requirements.

$$\varphi_M < \varphi_{Mi} < \chi_s + E_g \quad (3)$$

Where $\varphi_M$ is the work function of the first conductive layer 150, $\varphi_{Mi}$ is the work function of the second conductive layer 131, $\chi_s$ is electron affinity of the semiconductor layer 111, and $E_g$ is bandgap energy of the semiconductor layer 111.

When the first conductive layer 150 is ITO and the semiconductor layer 111 is p-Si, the second conductive layer 131 may be, for example, Cu or Ni.

In the energy band diagrams shown in FIGS. 4A and 4B, the work function ($\varphi_{Mi}$) of the second conductive layer 131 is shown according to the requirements of Equation (3).

The Schottky-barrier height (energy) ($\varphi_B$) may be expressed by the following equation.

$$\phi_B = E_g - (\phi_{Mi} - \chi_s) \quad (4)$$

When the first conductive layer 150 is ITO, the second conductive layer 131 is Cu (111), and the semiconductor layer 111 is p-Si, $\varphi_B$ becomes 1.12-(4.98-4.05)=0.19 (eV) according to Equation (4).

When the first conductive layer 150 is ITO, the semiconductor layer 111 is p-Si, and the second conductive layer 131 is Ni (110), $\varphi_B$ becomes 1.12-(5.04-4.05)=0.13 (eV) according to Equation (4).

A Schottky-barrier height due to the combination of ITO and p-Si may be calculated by the formula $E_g$-($\varphi_M$-$\chi_s$), and is 1.12-(4.7-4.05)=0.47(eV).

As such, also in the case of the photodiode 101 of the example embodiment of FIG. 3 in which the semiconductor layer 111 is p-type, the Schottky-barrier height (energy) is lower than a Schottky-barrier height (energy) when the material of the first conductive layer 150 and the material of the semiconductor layer 110 are combined. When the Schottky-barrier height is reduced, light energy that may be sensed by the photodiode 101 is lowered, so that light having a longer wavelength may be sensed.

When a Schottky junction is provided by combining a conductive layer and a semiconductor layer, like the photodiodes 100 and 101 described above, due to internal photoemission effect (IPE) caused by light absorption inside the conductive layer, photocurrent generation is possible only with incident light energy that crosses a Schottky barrier. Therefore, unlike a typical silicon P-N junction structure that may sense only light in a visible light band, it is possible to sense light in a wide wavelength band including light having a longer wavelength than visible light.

The photodiodes 100 and 101 of the above-described example embodiment may also sense light by two mechanisms: internal photoemission (IPE) and photovoltaic (PV). In other words, when the energy (hv) of incident light is greater than the Schottky-barrier height ($\varphi_B$) and less than the bandgap energy (Eg) of the semiconductor layer, that is, when Eg > hv > $\varphi_B$, the light is sensed by IPE action. When the energy (hv) of the incident light is greater than the bandgap energy (Eg) of the semiconductor layer, that is, when hv > Eg, the light is sensed by the PV action.

As described above, the photodiodes 100 and 101 of the example embodiment may reduce the Schottky barrier and generate a photocurrent through two actions, thereby efficiently sensing light in a wide wavelength band, for example, light in a wavelength band including both a visible light band and an infrared band. The photodiodes 100 and 101 of the embodiment may sense light in a wavelength band of, for example, 400 nm to 1700 nm.

The photodiodes 100 and 101 of the example embodiment may be driven even at a voltage lower than that of P-N junction when a reverse voltage is applied, and may be switched between forward and reverse bias at high speed, thereby enabling high-speed switching. In addition, because a CMOS process is simpler than P-N junction technology, mass production costs are reduced.

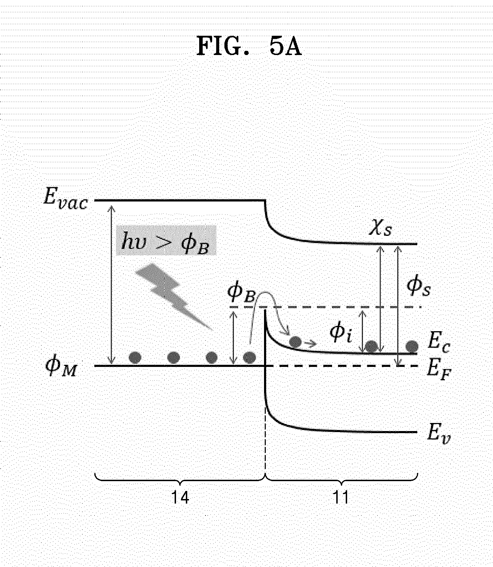

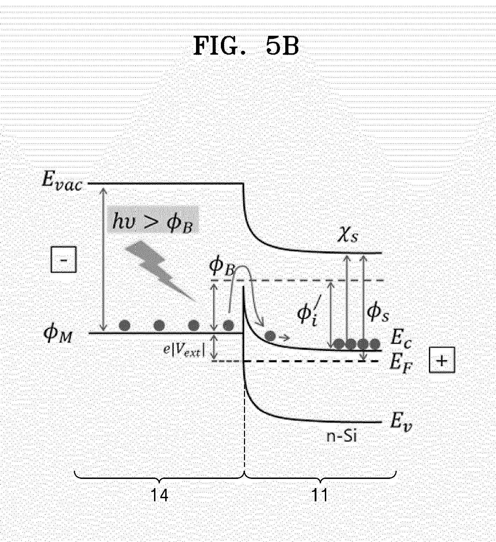

FIGS. 5A and 5B are respectively energy band diagrams of a photodiode according to a comparative example for a state in which there is no bias voltage and a state in which a reverse bias voltage is applied.

In the comparative example, the photodiode has a structure in which a semiconductor layer 11 and a conductive layer 14 are joined to form a Schottky barrier, and the semiconductor layer 11 is n-type. When the energy (hv) of the incident light is greater than the Schottky-barrier height ($\varphi_B$) and less than the bandgap energy (Eg) of the semiconductor layer, that is, when Eg > hv > $\varphi_B$, the light is sensed by the IPE action. When the energy (hu) of the incident light is greater than the band gap energy (Eg) of the semiconductor layer 11, that is, when hu > Eg, such light in a visible light band is mostly reflected by the conductive layer 14 made of a metallic material. However, the visible light can pass through the conductive layer 14 and is absorbed in the semiconductor layer 11 when the conductive layer 14 is a transparent conductive material or a very thin metal film.

If the conductive layer 14 is made of a transparent conductive material such as ITO, when the semiconductor layer is n-Si, the Schottky-barrier height is calculated by the formula $\varphi_M$ -$\chi_s$, and is 4.7-4.05=0.65 (eV). This value is greater than the Schottky barrier 0.45 eV in the case of an example embodiment in which a conductive layer of a work function different from ITO, for example, TiN, is between ITO and n-Si, as seen in the description of FIG. 2A. In other words, in the case of the comparative example, unlike the embodiment, light having a light energy of less than 0.65 eV cannot be sensed.

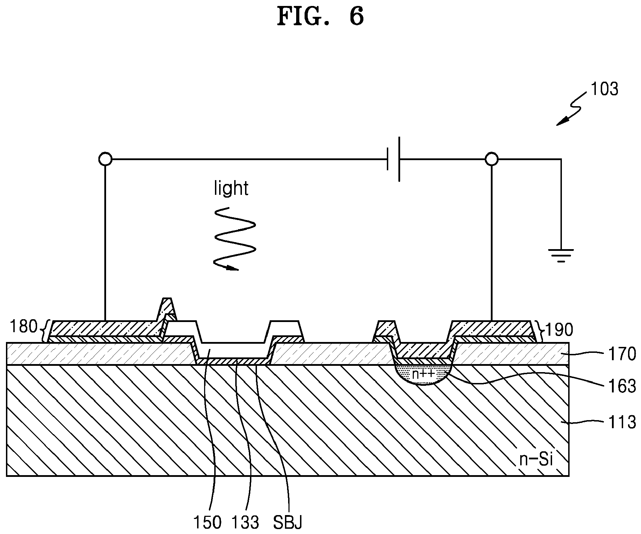

FIGS. 6 to 9 are cross-sectional views illustrating schematic structures of various examples of photodiodes implemented on a silicon substrate.

Referring to FIG. 6, a photodiode 103 includes a second conductive layer 133 and a first conductive layer 150 formed on an n-type silicon substrate 113. The Schottky junction structure SBJ is formed at the interface between the silicon substrate 113 and the second conductive layer 133.

Electrodes for applying an electrical signal to the Schottky junction structure SBJ or measuring an electrical signal generated from the Schottky junction structure SBJ may be further formed on the silicon substrate 113. For example, as shown, a first electrode 180 in electrical contact with the first conductive layer 150 and a second electrode 190 spaced apart from the first conductive layer 150 and in electrical contact with the silicon substrate 113 may be arranged. An ohmic contact area 163 doped with an n-type dopant at a higher concentration than in other areas may be formed in a partial area of the silicon substrate 113. The second electrode 190 may be formed to contact the ohmic contact area 163. The first electrode 180 may be formed in a shape in contact with a portion of side and upper surfaces of the first conductive layer 150 and the second conductive layer 133, and this is exemplary. The first electrode 180 may have various shapes capable of electrically contacting the first conductive layer 150 while securing an opening through which light is incident through the first conductive layer 150.

Each of the first electrode 180 and the second electrode 190 may be formed of a plurality of layers, and may include, for example, a Ti of TiN layer and a Mo or W or Al layer. However, the disclosure is not limited thereto, and as such, each of the first electrode 180 and the second electrode 190 may be formed of different materials and/or layers according to another example embodiment. An insulating layer 170 may be formed between each of the first electrode 180 and the second electrode 190 and the silicon substrate 113.

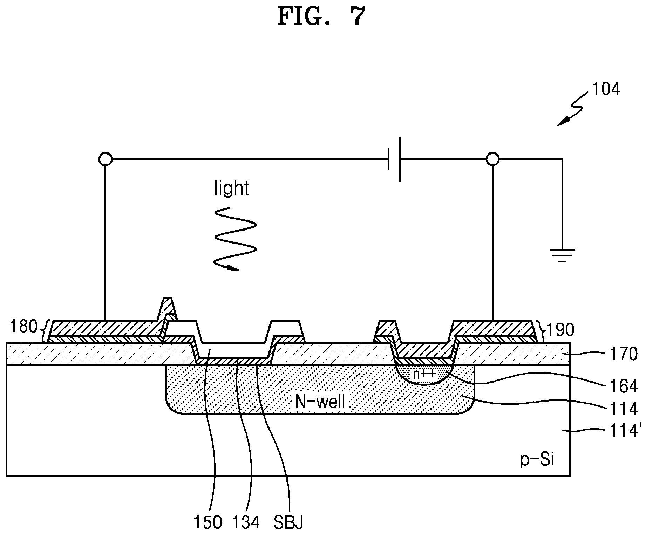

Referring to FIG. 7, a photodiode 104 includes a second conductive layer 134 and the first conductive layer 150 formed on a p-type silicon substrate 114'. An n-type well layer 114 is formed in a partial area of the p-type silicon substrate 114', and the Schottky junction structure SBJ is formed at the interface between the n-type well layer 114 and the second conductive layer 134. A partial area of the n-type well layer 114 is heavily doped with an n-type dopant to form an ohmic contact area 164, and the second electrode 190 is formed to contact the ohmic contact area 164.

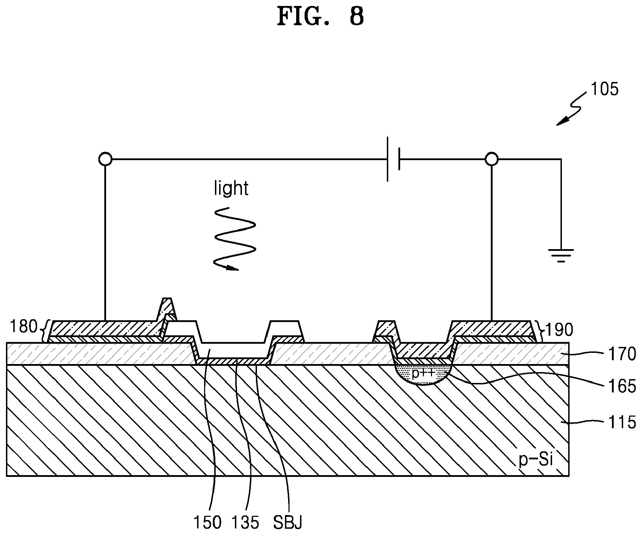

Referring to FIG. 8, a photodiode 105 includes a second conductive layer 135 and the first conductive layer 150 formed on a p-type silicon substrate 115. The Schottky junction structure SBJ is formed at the interface between the silicon substrate 115 and the second conductive layer 135. An ohmic contact area 165 doped with a p-type dopant at a higher concentration than in other areas may be formed in a partial area of the silicon substrate 115. The second electrode 190 may be formed to contact the ohmic contact area 165.

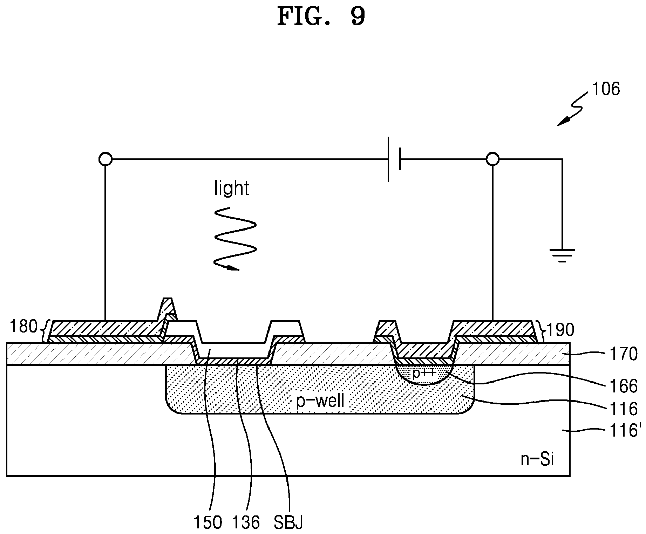

Referring to FIG. 9, a photodiode 106 includes a second conductive layer 136 and the first conductive layer 150 formed on an n-type silicon substrate 116'. A p-type well layer 116 is formed in a partial area of the n-type silicon substrate 116', and the Schottky junction structure SBJ is formed at the interface between the p-type well layer 116 and the second conductive layer 136. A partial area of the p-type well layer 116 is heavily doped with an p-type dopant to form an ohmic contact area 166, and the second electrode 190 is formed to contact the ohmic contact area 166.

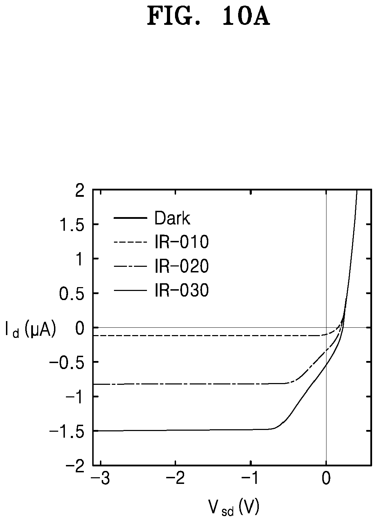

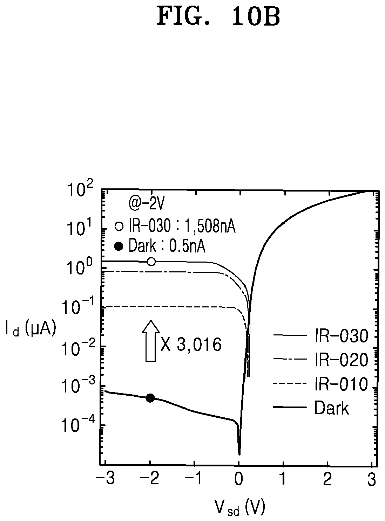

FIGS. 10A and 10B are graphs illustrating photoelectric signal measurement results for a photodiode according to an example embodiment, and are a linear plot and a log plot, respectively.

FIGS. 10A and 10B are for an ITO-TiN-nSi structure, and show results of measuring a current signal by light having a wavelength of 980 nm according to an applied voltage. It is measured that when light with a wavelength of 980 nm is incident under the voltage condition where a dark current is measured to be about 0.5 nA, a photocurrent that is about 3016 times higher than that of the dark current is generated.

The photodiode described above may exhibit high external quantum efficiency for light in a wide wavelength band. In such a photodiode, an operating wavelength band may be determined by appropriately setting the material of the second conductive layer in relation to a first conductive layer and the semiconductor layer, and the photodiode may be used as an optical sensor suitable for light in various wavelength bands.

The photodiode described above may be utilized as an image sensor of a general camera for obtaining a visible light image, and may be utilized as an image sensor suitable for night and crime prevention cameras by utilizing near infrared (NIR or short wavelength infrared; SWIR). In addition, the photodiode described above may be used as an image sensor suitable for a thermal imaging camera or a military camera that utilizes infrared (mid wavelength infrared; MWIR or long wavelength infrared; LWIR).

Hereinafter, various image sensors using the photodiode described above and electronic devices including the same will be described. As described above, because the operating wavelength band of the image sensor is adjusted according to a Schottky-barrier height formed on the photodiode, the operating wavelength band of the image sensor is not particularly limited in the following description.

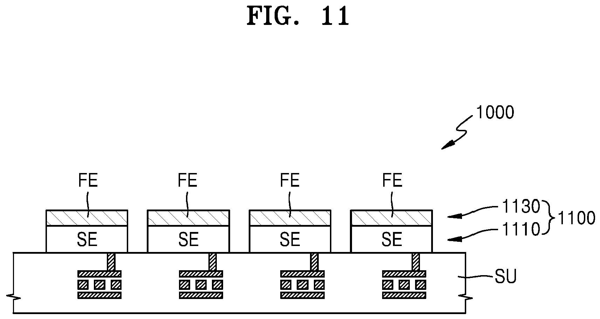

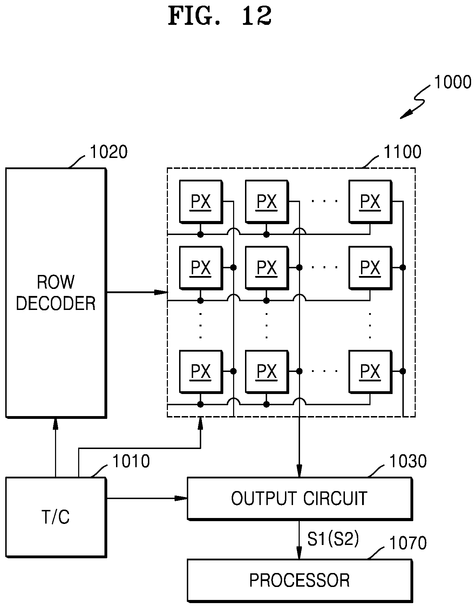

FIG. 11 is a cross-sectional view illustrating a schematic structure of an image sensor according to an example embodiment, and FIG. 12 is a block diagram illustrating a circuit configuration of the image sensor of FIG. 11.

An image sensor 1000 includes a pixel array 1100 including a plurality of pixels PX. The pixel array 1100 includes a sensor array 1110 including a plurality of light-sensing elements SE. Any one of the photodiodes 100, 101, 103, 104, 105, and 106 described above or a structure modified in combination therefrom may be employed for a light-sensing element SE of the sensor array 1110. A separation layer may be formed between adjacent light-sensing elements SE. A filter array 1130 including a plurality of filter elements FE respectively facing the plurality of light-sensing elements SE may be on the sensor array 1110. A filter element FE may be a band-pass filter for a certain wavelength band, and a filter element FE of an appropriate wavelength band may be set according to the type of image to be acquired by the image sensor 1000. The filter element FE may be, for example, a band pass filter of a visible light band or a band pass filter of an infrared band. The filter array 1130 may include a plurality of types of filter elements FE that transmit a plurality of different wavelength bands. The filter array 1130 may be a general color filter. The light-sensing element SE and the filter element FE arranged corresponding thereto may be referred to as a pixel PX hereinafter.

The image sensor 1000 also includes circuit unit including circuit elements respectively connected to the plurality of light-sensing elements SE and configured to read a photoelectric signal generated from each of the plurality of light-sensing elements SE. At least a portion of the circuit unit may be provided on a circuit board SU shown in FIG. 12, and the light-sensing elements SE may be on the circuit board SU to be connected to circuit elements in the circuit board SU.

The image sensor 1000 may include the pixel array 1100, a timing controller 1010, a row decoder 1020, an output circuit 1030, and a processor 1070.

The pixels PX of the pixel array 1100 may be two-dimensionally arranged along a plurality of rows and columns. The row decoder 1020 selects one of the rows of the pixel array 1100 in response to a row address signal output from the timing controller 1010. The output circuit 1030 outputs a light-sensing signal from a plurality of pixels arranged along a selected row in units of columns. To this end, the output circuit 1030 may include a column decoder and an analog-to-digital converter (ADC). For example, the output circuit 103 may include a plurality of ADCs respectively arranged for each column between the column decoder and the first pixel array 1100, or one ADC arranged at an output terminal of the column decoder.

The processor 1070 may process an electrical signal from the output circuit 1030 to form an image. Because the pixels PX provided in the image sensor 1000 according to an example embodiment use a photodiode capable of sensing light in both a visible light band and an infrared band as the light-sensing element SE, the electrical signal output from the output circuit 1030 may include a photoelectric signal S1 by visible light and/or a photoelectric signal S2 by infrared. Accordingly, the processor 1070 may process these signals to form a visible light image and/or an infrared image, and may form a 3D image. For example, after forming a 2D image from the photoelectric signal S1 by visible light and calculating depth information of each position of the 2D image from the photoelectric signal S2 by infrared using a time of flight (ToF) method, etc., the depth information may be combined with the two-dimensional image to form a three-dimensional image.

The timing controller 1010, the row decoder 1020, the output circuit 1030, and the processor 1070 may be implemented as one chip or as separate chips.

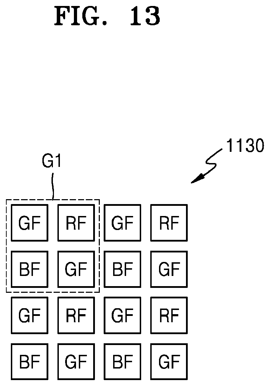

FIGS. 13 to 15 are plan views illustrating examples of filter arrays that may be included in the image sensor of FIG. 11.

Referring to FIG. 13, the filter array 1130 includes a red filter RF, a green filter GF, and a blue filter BF. As shown, two green filters GF, one red filter RF, and one blue filter BF form one filter group G1 to form a pixel arrangement of a Bayer pattern, and the filter group G1 may be two-dimensionally arranged. When the filter array 1130 is applied to the image sensor 1000, the processor 1070 of the image sensor 1000 may process a signal for each pixel to form a visible light image.

In FIG. 13, the filter group G1 having a color arrangement in the form of a Bayer pattern to form a visible light image is exemplified, but the disclosure is not limited thereto. For example, a filter group may be formed in an RGBW method using a red, green, blue, and white color arrangement or a CMGY type using a cyan, magenta, green, and yellow color arrangement, and a visible light image may be formed by using them.

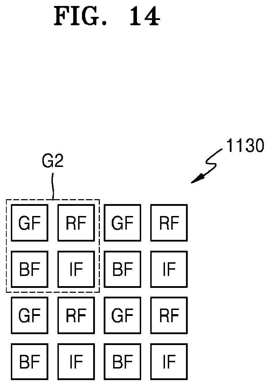

Referring to FIG. 14, the filter array 1130 may include the red filter RF, the green filter GF, the blue filter BF, and an infrared filter IF. The red filter RF, the green filter GF, the blue filter BF, and the infrared filter IF may form one filter group G2, and a plurality of filter groups G2 may be two-dimensionally arranged.

When the filter array 1130 is applied to the image sensor 1000, the processor 1070 of the image sensor 1000 may process a signal for each pixel to form two types of images, that is, a visible light image and an infrared image.

The image sensor 1000 may form a 3D image. For example, after forming a 2D image from electrical signals in pixels corresponding to the red filter RF, the green filter GF, and the blue filter BF and calculating depth information of each position of the 2D image from an electric signal in a pixel corresponding to the infrared filter IF by a ToF method, etc., the depth information may be combined with the two-dimensional image to form a three-dimensional image.

In FIG. 14, the red filter RF, the green filter GF, the blue filter BF, and the infrared filter IF are all illustrated with the same number, but this is exemplary and the disclosure is not limited thereto. For example, the infrared filter IF may be provided in different numbers and/or different arrangements.

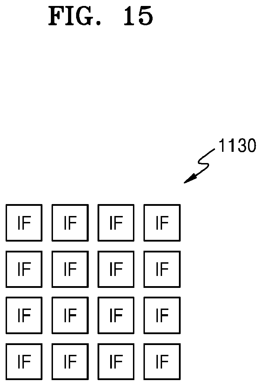

Referring to FIG. 15, all of filter elements of the filter array 1130 may be infrared filters IF. When the filter array 1130 is applied to the image sensor 1000, the processor 1070 of the image sensor 1000 may process a signal for each pixel to form an infrared image.

The filter array 1130 shown in FIG. 15 may be configured as a single filter without dividing areas as shown. Alternatively, the infrared filter IF may include a plurality of different types of infrared filters IF in a transmission wavelength band.

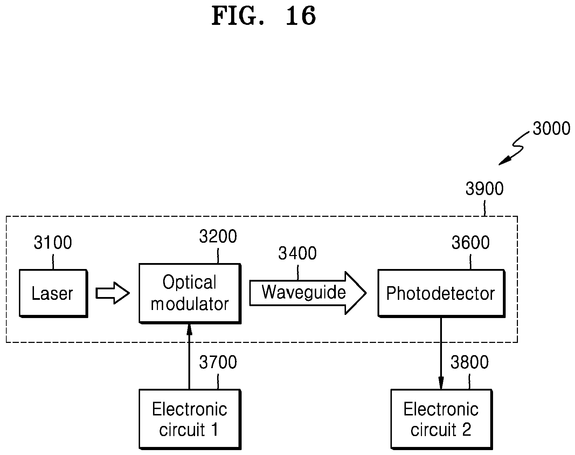

FIG. 16 is a block diagram conceptually illustrating an exemplary configuration of an optical integrated circuit according to an example embodiment.

An optical integrated circuit 3000 may include a light source 3100, an optical waveguide 3400 for transmitting light from the light source 3100, and a photodetector 3600 that converts light transmitted through the optical waveguide 3400 into an electrical signal. The photodetector 3600 may include any one of the photodiodes 100, 101, 103, 104, 105 described above, and 106 or a modified structure thereof.

Such a structure may be, for example, a portion of a circuit constituting an optical transceiver. The optical integrated circuit 3000 may further include an optical modulator 3200 arranged between the light source 3100 and the optical waveguide 3400, an electronic circuit 3700 for applying a modulation signal to the optical modulator 3200, and an electronic circuit 3800 to which an electrical signal converted by the photodetector 3600 is transmitted. A coupler may be between the light source 3100, the optical modulator 3200, the optical waveguide 3400, and the photodetector 3600, and in addition, configurations such as a passive circuit, an isolator, a duplexer, a splitter, and a filter may be further included.

The light source 3100, the optical modulator 3200, the optical waveguide 3400, and the photodetector 3600 may be on an identical substrate 3900. The substrate 3900 may be a silicon substrate, and the photodetector 3600 may be a photodiode using a silicon semiconductor.

The light source 3100 may be, for example, a laser emitting light in a wavelength band of 800 nm to 1700 nm. In order to sense light in this wavelength band and convert the light into an electrical signal, a photodiode of a III-V semiconductor substrate is usually used, but high process difficulty and cost are required to form the photodiode on a silicon substrate. As in the embodiment, by applying a silicon-based photodiode capable of sensing light in a wide wavelength band to the photodetector 3600, the optical integrated circuit 3000 that may utilize the advantages of silicon photonics, for example, large-capacity information transfer, ultra-high-speed processing, minimum transmission loss, and reduced energy consumption, may be implemented.

The photodiode described above, an image sensor and an electronic device including the same have been described with reference to the embodiment shown in the drawings, but this is only an example. Descriptions of features or aspects within each embodiment should typically be considered as available for other similar features or aspects in other embodiments. It should be understood that embodiments described herein should be considered in a descriptive sense only and not for purposes of limitation. The scope of the specification is indicated in the claims rather than the above description, and all differences within the scope of equivalents should be construed as being included in the scope of the disclosure.

The photodiode described above may sense light in a wide wavelength band including a visible light band and an infrared band.

The photodiode described above may have a simple structure and exhibit high external photon efficiency.

The photodiode described above may be driven at a lower voltage than general P-N junction, and high-speed switching is possible. In addition, because the CMOS process is simpler than P-N junction technology, mass production costs are reduced.

The photodiode described above may provide an image sensor applicable to various wavelength bands, and a camera module including the image sensor described above may be utilized in various electronic devices.

The photodiode described above may be easily utilized in silicon photonics.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A photodiode comprising:

   a semiconductor layer;
   a first conductive layer provided on the semiconductor layer; and
   a second conductive layer arranged between the semiconductor layer and the first conductive layer, the second conductive layer configured to have a second work function different from a first work function of the first conductive layer, and configured to form a Schottky junction structure with the semiconductor layer.

2. The photodiode of claim 1, wherein the first conductive layer includes a metallic layer having a thickness less than 10nm or includes a transparent conductive oxide.

3. The photodiode of claim 1 or 2, wherein the second work function of the second conductive layer is set to have a second Schottky-barrier height of the Schottky junction structure lower than a first Schottky-barrier height of a Schottky junction structure in which a material of the first conductive layer and a material of the semiconductor layer are combined.

4. The photodiode of any preceding claim, wherein the semiconductor layer is of an n-type, and the second work function of the second conductive layer satisfies the following condition:

$$\varphi_M > \varphi_{Mi} > \chi_s,$$

wherein $\varphi_M$ is the work function of the first conductive layer, $\varphi_{Mi}$ is the work function of the second conductive layer, and $\chi_s$ is electron affinity of the semiconductor layer.

5. The photodiode of any of claims 1 to 3, wherein the semiconductor layer is of a p-type, and the second work function of the second conductive layer satisfies the following condition:

$$\varphi_M < \varphi_{Mi} < \chi_s + E_g,$$

wherein $\varphi_M$ is the work function of the first conductive layer, $\varphi_{Mi}$ is the work function of the second conductive layer, $\chi_s$ is electron affinity of the semiconductor layer, and $E_g$ is bandgap energy of the semiconductor layer.

6. The photodiode of any preceding claim, wherein the second conductive layer comprises a metal, an alloy, a metal oxide, a metal nitride, or a silicide.

7. The photodiode of any preceding claim, wherein a thickness of the second conductive layer is greater than 0 and less than or equal to 10 nm.

8. The photodiode of any preceding claim, further comprising:

a silicon substrate,
wherein the semiconductor layer is a partial area of the silicon substrate, and optionally further comprising a plurality of electrodes provided on the silicon substrate, the plurality of electrodes configured to apply an electrical signal to the Schottky junction structure or to measure an electrical signal generated in the Schottky junction structure.

9. The photodiode of claim 8, wherein the silicon substrate further comprises an ohmic contact area spaced apart from the Schottky junction structure, the ohmic contact area having a higher doping concentration than a doping concentration of the semiconductor layer, and optionally further comprising:

a first electrode in electrical contact with the first conductive layer, and
a second electrode in electrical contact with the ohmic contact area.

10. The photodiode of any preceding claim, wherein the photodiode is configured to sense light in visible and infrared bands.

11. An image sensor comprising:

a sensor array including a plurality of light-sensing elements, each of the plurality of light-sensing elements including a photodiode according to any preceding claim; and
a processor configured to read a photoelectric signal generated from each of the plurality of light-sensing elements.

12. The image sensor of claim 11, further comprising a filter array provided on the sensor array and including a plurality of filter elements respectively facing the plurality of light-sensing elements, and optionally wherein the plurality of filter elements include a red filter, a blue filter, and a green filter, and the processor is further configured to process the photoelectric signal to form a visible light image.

13. The image sensor of claim 12, wherein the filter element includes an infrared band-pass filter, and the processor is further configured to process the photoelectric signal to form an infrared image.

14. An optical integrated circuit comprising:

a substrate;
a light source on the substrate;
an optical waveguide configured to transmit light from the light source; and
a photodiode according to any of claims 1 to 10 configured to convert the light transmitted through the optical waveguide into an electrical signal.

15. The optical integrated circuit of claim 14, wherein the light source is configured to output light in a wavelength range of 800 nm to 1,700 nm.

# FIG. 1

# FIG. 2A

# FIG. 2B

# FIG. 3

FIG. 4A

# FIG. 4B

FIG. 5A

# FIG. 5B

# FIG. 6

# FIG. 7

# FIG. 8

# FIG. 9

# FIG. 10A

# FIG. 10B

# FIG. 11

# FIG. 12

# FIG. 13

1130

G1

| GF | RF | GF | RF |
| BF | GF | BF | GF |
| GF | RF | GF | RF |
| BF | GF | BF | GF |

# FIG. 14

G2

1130

| GF | RF | GF | RF |
| BF | IF | BF | IF |
| GF | RF | GF | RF |
| BF | IF | BF | IF |

# FIG. 15

1130

| IF | IF | IF | IF |
|----|----|----|----|
| IF | IF | IF | IF |
| IF | IF | IF | IF |
| IF | IF | IF | IF |

# FIG. 16

3000

3900

| 3100 | 3200 | 3400 | 3600 |
|------|------|------|------|

Laser ⇒ Optical modulator ⇒ Waveguide ⇒ Photodetector

3700

Electronic circuit 1

3800

Electronic circuit 2

Europäisches
Patentamt

European
Patent Office

Office européen
des brevets

# EUROPEAN SEARCH REPORT

Application Number

EP 22 19 7722

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2020/202736 A1 (PANASONIC IP MAN CO LTD [JP]) 8 October 2020 (2020-10-08) * abstract; figures 1A-1K,3A-3C,4A-4B,5 * * paragraphs [0001] - [0002], [0008] - [0026], [0028] - [0065], [0075] - [0087], [0091] - [0092], [0095] - [0116] * | 1-15 | INV. H01L31/108 H01L31/0224 H01L31/12 H01L27/146 |
| X | US 2007/057339 A1 (MITSUI TETSURO [JP] ET AL) 15 March 2007 (2007-03-15) * abstract; figures 1,2,3,4,5 * * paragraphs [0001], [0006] - [0034], [0047] - [0050], [0072] - [0083], [0091], [0100] - [0109], [0112] - [0124], [0137] - [0147] * | 1-12 | |
| X | JP 2012 234949 A (PANASONIC CORP) 29 November 2012 (2012-11-29) * abstract; figures 4, 11 * * paragraphs [0007], [0039] - [0054] * | 1,2,7, 11,12 | |
| X | WO 2021/140743 A1 (PANASONIC IP MAN CO LTD [JP]) 15 July 2021 (2021-07-15) * abstract; figures 1,6 * * paragraphs [0011] - [0016], [0030], [0034], [0038], [0047], [0059], [0061], [0068], [0096] - [0098] * | 1-15 | TECHNICAL FIELDS SEARCHED (IPC) H01L |

-/--

The present search report has been drawn up for all claims

| Place of search | Date of completion of the search | Examiner |
|---|---|---|
| Berlin | 3 March 2023 | Sagol, Bülent Erol |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

**EP 22 19 7722**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LI XINXIN ET AL: "Hybrid nano-scale Au with ITO structure for a high-performance near-infrared silicon-based photodetector with ultralow dark current", PHOTONICS RESEARCH, vol. 8, no. 11, 9 October 2020 (2020-10-09), pages 1662-1670, XP093028603, DOI: 10.1364/PRJ.398450 * abstract; figures 1d,4; table 1 * * page 1663, left-hand column - page 1664, left-hand column * * page 1666 * | 1-15 | |
| A | US 2014/014838 A1 (HENDRIX KAREN DENISE [US] ET AL) 16 January 2014 (2014-01-16) * the whole document * | 1,11-13 | |

TECHNICAL FIELDS
SEARCHED (IPC)

The present search report has been drawn up for all claims

| Place of search | Date of completion of the search | Examiner |
|---|---|---|
| Berlin | 3 March 2023 | Sagol, Bülent Erol |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 19 7722

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2023

| Patent document cited in search report | | Publication date | Patent family member(s) | | Publication date |
|---|---|---|---|---|---|
| WO 2020202736 | A1 | 08-10-2020 | CN | 113518754 A | 19-10-2021 |
| | | | JP | WO2020202736 A1 | 08-10-2020 |
| | | | US | 2021391373 A1 | 16-12-2021 |
| | | | WO | 2020202736 A1 | 08-10-2020 |
| US 2007057339 | A1 | 15-03-2007 | JP | 2007081137 A | 29-03-2007 |
| | | | US | 2007057339 A1 | 15-03-2007 |
| | | | US | 2011233701 A1 | 29-09-2011 |
| JP 2012234949 | A | 29-11-2012 | NONE | | |
| WO 2021140743 | A1 | 15-07-2021 | CN | 114868259 A | 05-08-2022 |
| | | | JP | WO2021140743 A1 | 15-07-2021 |
| | | | US | 2022310868 A1 | 29-09-2022 |
| | | | WO | 2021140743 A1 | 15-07-2021 |
| US 2014014838 | A1 | 16-01-2014 | AT | 17188 U1 | 15-08-2021 |
| | | | CA | 2879363 A1 | 23-01-2014 |
| | | | CA | 3144943 A1 | 23-01-2014 |
| | | | CN | 104471449 A | 25-03-2015 |
| | | | CN | 108459368 A | 28-08-2018 |
| | | | CN | 115542448 A | 30-12-2022 |
| | | | CN | 115586597 A | 10-01-2023 |
| | | | CY | 1120895 T1 | 11-12-2019 |
| | | | DE | 202013012851 U1 | 09-07-2020 |
| | | | DK | 2872935 T3 | 08-10-2018 |
| | | | EP | 2872935 A2 | 20-05-2015 |
| | | | EP | 3467552 A1 | 10-04-2019 |
| | | | EP | 3467553 A1 | 10-04-2019 |
| | | | ES | 2691620 T3 | 28-11-2018 |
| | | | HK | 1253916 A1 | 05-07-2019 |
| | | | HR | P20181701 T1 | 28-12-2018 |
| | | | HU | E040755 T2 | 28-03-2019 |
| | | | KR | 20150031336 A | 23-03-2015 |
| | | | KR | 20180008898 A | 24-01-2018 |
| | | | KR | 20190031347 A | 25-03-2019 |
| | | | KR | 20190080984 A | 08-07-2019 |
| | | | KR | 20190080985 A | 08-07-2019 |
| | | | KR | 20200060529 A | 29-05-2020 |
| | | | LT | 2872935 T | 12-11-2018 |
| | | | PL | 2872935 T3 | 28-02-2019 |
| | | | PT | 2872935 T | 05-11-2018 |
| | | | SI | 2872935 T1 | 30-11-2018 |
| | | | TW | 201411200 A | 16-03-2014 |
| | | | TW | 201732324 A | 16-09-2017 |
| | | | TW | 201920997 A | 01-06-2019 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 22 19 7722

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2023

| Patent document cited in search report | Publication date | Patent family member(s) | | Publication date |
|---|---|---|---|---|
| | | TW 202028783 A | | 01-08-2020 |
| | | US 2014014838 A1 | | 16-01-2014 |
| | | US 2016231483 A1 | | 11-08-2016 |
| | | US 2016266289 A1 | | 15-09-2016 |
| | | US 2017336544 A1 | | 23-11-2017 |
| | | US 2019196072 A1 | | 27-06-2019 |
| | | US 2021396919 A1 | | 23-12-2021 |
| | | WO 2014014930 A2 | | 23-01-2014 |

EPO FORM P0459

For more details about this annex : see Official Journal of the European Patent Office, No. 12/82